# EUROPEAN PATENT APPLICATION

(11) **EP 2 096 905 A1**
(43) Date of publication of application: **02.09.2009**
(21) Application number: 08425114.9
(22) Date of filing: 26.02.2008
(51) Int. Cl.: H05K 3/34, B23K 35/26

(54) **Process for mounting electronic and/or electro-optical devices on an electronic board**

(71) Applicant: ROAL ELECTRONICS S.p.A., 60022 Castelfidardo (AN) (IT)
(72) Inventor: Mancini, Stefano Roal Electronics S.p.A., 60022 Castelfidardo (Ancona) (IT)
(74) Representative: Baroni, Matteo

(57) **Abstract**

A process for mounting electronic and/or electro-optical devices on electronic boards comprising: providing an electronic board (6); laying a solder material (5) comprising a tin-bismuth alloy on said electronic board (6); positioning one or more electronic and/or electro-optical devices (1, 1a) on said board (6), thus obtaining a corresponding semi-finished product; heating said semi-finished product to allow melting of said solder material (5); cooling said semi-finished product to enable solidification of said solder material (5).

## Description

The present invention relates to a process for mounting electronic and/or electro-optical devices on an electronic board.

It is known that devices of the electronic or electro-optical type (such as LED's = Light-Emitting Diodes, for example) are presently mounted on electronic boards through processes substantially involving a first step of the silk-screen type, in which a soldering cream is laid on the board, and a second step in which an adhesive substance is laid on the same board.

The first step aims at laying a material that when manufacture of the item has been completed, will allow an electric connection between the device and the remainder of the circuit on the board, while the second step aims at enabling a suitable heat dissipation for the device.

In more detail, as far as LED's are concerned, laying of the adhesive material at the so-called central "bump contact" of the LED, in addition to optimising heat dissipation, also allows a mechanical constraint to be obtained between the LED and the board on which the device is mounted.

A first drawback in this type of processes resides in that the double laying step (first the soldering cream and then the adhesive material) makes the time for carrying out the process very long, which will involve a limitation in the production efficiency.

A further drawback is the high cost, due to the expendable materials and the need for suitable apparatus adapted to perform the two distinct steps.

An additional drawback appears if we consider that some types of devices, such as "sensitive" power LED's, do not resist treatments in which temperature of same is raised beyond 120°-130°C. Should this temperature be overcome, very high risks of irreparably damaging the device and/or the lens associated therewith would exist, which will make the production process practically unacceptable.

Solders presently used (e.g. tin-lead alloys, lead-free alloys (SAC), etc.) have high melting temperatures that must be reached without too much raising the temperature that can be measured on the device to be soldered. Clearly, this makes LED-mounting and soldering processes of difficult and complicated accomplishment.

An alternative solution offered by the known art consists in "spot" soldering processes in which the device terminals are soldered on the bump contacts of the printed circuit by spot soldering operations carried out manually, by robots, or laser soldering tools.

It is however to be pointed out that automated apparatus and instruments for carrying out the above soldering processes are very complicated and expensive.

In addition, these processes are characterised by a very important waste of time, both when they are carried out manually (spot soldering is particularly complex and difficult to be executed manually), and when suitable apparatus are utilised (for which however a non negligible waste of time for setting up and calibration is required).

At all events, irrespective of how spot soldering is carried out, it is characterised by a very weak reliability which will make use of this technology still more critical.

Further known is use of electrically conductive adhesive materials, typically silver-based materials, which however involve costs that cannot be industrially borne for mass production, as well as weak reliability in terms of mechanical constraint of the device and intrinsic difficulty in carrying out the process, since adhesive materials of this type must be preserved to temperatures in the order of -20°C and must be used very quickly.

Finally, should different types of devices be mounted on the board (e.g. LED's together with active or passive electronic devices), it is always necessary to execute a double soldering cycle consisting of a first step to a standard temperature of 217°C for example, and a second cycle to controlled and lower temperatures, which second cycle is dedicated to power LED's.

Accordingly, the present invention aims at providing a process for mounting electronic and/or electro-optical devices on electronic boards that is quick and of easy execution.

It is a further aim of the invention to provide a process enabling complexity of the apparatus and instruments by means of which it is carried out to be reduced.

Another aim of the invention is to make available a process enabling a reliable connection to be obtained, both from an electric and a mechanical point of view, between the device and the board on which the latter is mounted.

A further aim of the invention is to make available a process that does not impair the qualities, features and good operation of the devices that are mounted on the board.

A still further aim of the invention is to provide a process allowing a reduction to be achieved in the overall costs for mounting of said electronic and/or electro-optical devices.

Another aim of the invention is to make available a process by which also different types of electronic and/or electro-optical devices can be mounted in a quick and reliable manner.

The foregoing and further aims are substantially achieved by a process for mounting electronic and/or electro-optical devices on electronic boards in accordance with the features recited in the appended claims.

Further features and advantages will become more apparent from the detailed description of a preferred but not exclusive embodiment of the invention. This description is taken with reference to the accompanying drawings, given by way of non-limiting example, in which:
- Figs. 1a and 1b diagrammatically show a device that can be soldered by the process in accordance with the invention;
- Fig. 2 diagrammatically shows a step of carrying out the process of mounting the device seen in Figs. 1a, 1b on an electronic board;
- Fig. 3 diagrammatically shows a board on which devices are mounted by adopting the method of the invention.

The process of the invention applies to the field of surface mount of electronic, opto-electronic, electro-optical, etc. devices (SMD) on electronic boards.

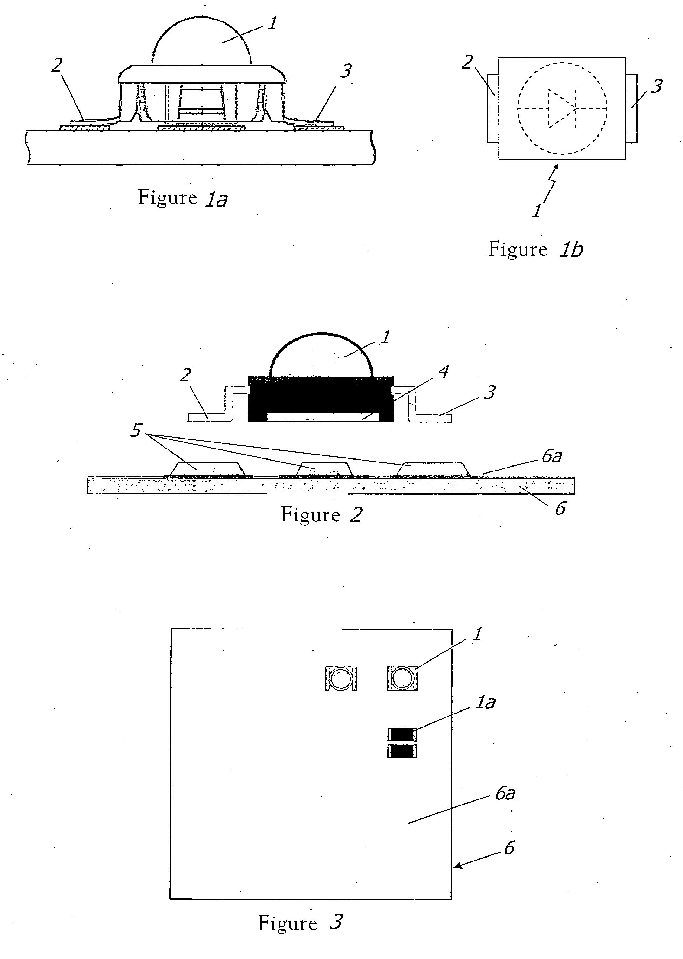

The inventive process first of all comprises a step of providing an electronic board 6 (diagrammatically shown in Figs. 2 and 3).

The electronic board 6 has a printed circuit on a surface 6a thereof, which circuit is designed to be associated with one or more electronic and/or electro-optical devices.

The electronic board 6 can be formed with FR4 (Flame Retardant 4) or with an aluminium or copper substrate (MC-PCB).

The process according to the invention further comprises a step of laying a solder material comprising a tin-bismuth solder or alloy 5 on the electronic board 6 and in particular on surface 6a.

Preferably, the tin-bismuth solder 5 comprises a percentage of 30% to 50%, and in particular of 40% to 45%, of tin by weight; by way of example, the percent by weight of tin can be of about 43%.

Preferably, the tin-bismuth solder 5 comprises a percent by weight of bismuth included between 50% and 70% and in particular between 55% and 60%; by way of example, the percent by weight of tin can be of about 57%.

Preferably, the melting temperature of alloy 5 is included between 130°C and 150°C, and in particular between 135°C and 140°C; by way of example, this melting temperature can be of about 138°C.

Practically, for carrying out the process of the invention an alloy having the standard code J-STD-006 can be employed, the features of said alloy being summarised in the following table:

| | |
|---|---|
| Alloy for solder paste: | Tin-Bismuth |
| Composition (% by weight): | Tin: 43% - Bismuth: 57% |
| Metal content: | 87-88% |
| Particle size: | 38-53µ, |
| Melting point: | 138°C |
| Standard reference: | J-STD-006 |

The process according to the invention further comprises a step of positioning said one or more electronic and/or electro-optical devices on the electronic board 6, and in particular on one or more respective areas on which the solder material 5 has been laid.

Preferably, said one or more electronic and/or electro-optical devices comprise at least one LED 1.

LED 1 has a predetermined number of electric contacts (two electric contacts, for example), 2, 3 and a dissipation region 4.

Preferably, the solder material 5 is interposed between the electronic board 6 and LED 1 so that said material is positioned both at the electric contacts 2, 3 and at the dissipation region 4.

In this manner, the solder material 5 is used both for an electric connection between LED 1 and the electronic board 6, and for a mechanical constraint between the same elements to enable a suitable dissipation of the heat produced by said LED 1.

Therefore, advantageously, the solder material 5 is laid on the electronic board 6 by a single laying step, since the solder material 5 is able to obtain all necessary effects for an efficient mounting of LED 1 (i.e. electric connection and heat dissipation).

In other words, laying of other solder and/or adhesive materials is not required, since the solder material 5 is sufficient to perform the different necessary functions.

In a preferably subsequent step, the semi-finished product thus obtained is heated following a predetermined thermal profile, to enable the solder material to melt and perform its fastening action.

This heating step can be performed by means of a reflow oven or a hot plate, for example.

Finally, the semifinished product is allowed to cool (until it reaches a temperature close to the room temperature, for example), so that the solder material 5 can solidify and complete the assembling process.

Advantageously, said electronic devices also comprise at least one device that is not a LED, denoted at 1a in Fig. 3, by way of example.

For instance, device 1a can be a resistor, a transistor, a capacitor, an inductor, etc., generally any device that can be soldered to the electronic board 6 following an SMD technology.

The invention achieves important advantages.

First of all, the process according to the invention can be carried out in a quick and simple manner. In particular, accomplishment of the process can take place by means of apparatus and instruments of reduced complexity.

A further advantage consists in that the inventive process allows a reliable both electric and mechanical connection to be obtained between the device and the board on which the latter is mounted.

Another advantage is found in that the mounting process does not impair the qualities, features and good operation of the devices mounted on said board.

In addition, advantageously, the overall costs for mounting said electronic and/or electro-optical devices are reduced.

A still further advantage resides in that the process of the invention can be efficiently used for mounting also different typologies of electronic and/or electro-optical devices in a quick and reliable manner.

## Claims

1. A process for mounting electronic and/or electro-optical devices on electronic boards, comprising:
- providing an electronic board (6);
- laying a solder material (5) comprising a tin-bismuth alloy on said electronic board (6);
- positioning one or more electronic and/or electro-optical devices (1, 1a) on said electronic board (6), thus obtaining a corresponding semi-finished product;
- heating said semi-finished product in order to allow melting of said solder material (5);
- cooling said semi-finished product to enable solidification of said solder material (5).

2. A process as claimed in claim 1, wherein said tin-bismuth solder comprises a percentage of 30% to 50%, and preferably of 40% to 45%, of tin by weight.

3. A process as claimed in anyone of the preceding claims, wherein said tin-bismuth solder comprises a percentage by weight of bismuth included between 50% and 70%, and preferably between 55% and 60%.

4. A process as claimed in anyone of the preceding claims wherein said tin-bismuth solder has a melting temperature in the range of 130°C to 150°C, and preferably of 135°C to 140°C.

5. A process as claimed in anyone of the preceding claims, wherein said electronic and/or electro-optical devices comprise at least one LED (1) having a predetermined number of electric contacts (2, 3) and a dissipation region (4).

6. A process as claimed in claim 5 wherein said solder material (5) is positioned both at the electric contacts (2, 3) and at the dissipation region (4) of said at least one LED (1).

7. A process as claimed in anyone of the preceding claims, wherein said electronic and/or electro-optical devices comprise at least one device (1a) that is not a LED.

8. A process as claimed in anyone of the preceding claims, wherein the step of heating said semi-finished product is carried out by means of a reflow oven.

9. A process as claimed in anyone of claims 1 to 7, wherein the step of heating said semi-finished product is carried out by means of a hot plate.

10. A process as claimed in claim 6, wherein said solder material (5) allows both an electric connection between said electric contacts (2, 3) and said electronic board (6), and a thermal conduction between said dissipation region (4) and electronic board (6).

11. A process as claimed in anyone of the preceding claims, wherein said solder material (5) is laid on said electronic board (6) in a single laying step.
